# EUROPÄISCHE PATENTSCHRIFT

(11) **EP 4 040 927 B1**
(45) Veröffentlichungstag und Bekanntmachung des Hinweises auf die Patenterteilung: **06.11.2024**
(21) Anmeldenummer: 22154961.1
(22) Anmeldetag: 03.02.2022
(51) Int. Cl.: H05K 5/00, H05K 7/00, H05K 7/14, F16B 23/00, F16B 5/08

(54) **BAUGRUPPE UMFASSEND EINE PLATINE UND EIN GRUNDTEIL**
ASSEMBLY COMPRISING A BOARD AND A BASE
MODULE COMPRENANT UNE PLATINE ET UNE PARTIE DE BASE

(30) Priorität: 05.02.2021 DE 102021102676
(43) Veröffentlichungstag der Anmeldung: 10.08.2022
(73) Patentinhaber: EJOT SE & Co. KG, 57319 Bad Berleburg (DE)
(72) Erfinder: Müller, Niko, 57319 Bad Berleburg (DE); Spring, Alexander, 57072 Siegen (DE); Engel, Danni, 24558 Henstedt-Ulzburg (DE)
(74) Vertreter: DREISS Patentanwälte PartG mbB

(56) Entgegenhaltungen:
- DE-A1- 102011 017 314

## Beschreibung

In vielen Gebieten der Technik, wie zum Beispiel in der Kraftfahrzeugtechnik oder der Luftfahrt, werden elektrische und elektronische Geräte mit Hilfe gedruckter Schaltungen realisiert. Die Leiterbahnen dieser Schaltungen werden auf eine Leiterplatte (Platine) aufgebracht. Anschließend wird die Leiterplatte mit elektrischen und/oder elektronischen Bauteilen bestückt. Es liegt auf der Hand, dass die auf die Platine aufgedruckten Schaltungen empfindlich auf Verschmutzungen, Feuchtigkeit und mechanische Belastungen reagieren. Daher ist es üblich, die Platinen auf einem Grundteil zu befestigen, welches einen mechanischen Schutz der Leiterplatte und der auf ihr angeordneten Bauteile bietet. Ggf. kann das Grundteil auch als geschlossenes Gehäuse ausgebildet sein, um das Eindringen von Feuchtigkeit oder Spritzwasser zu verhindern.

Üblicherweise werden die Platine und das Grundteil durch eine Schraubverbindung miteinander verbunden. Dazu sind an dem Grundteil sogenannte Schraubtuben ausgebildet. Die Schraubtuben bieten eine Auflagefläche für die Platine und weisen eine Bohrung auf in die eine bevorzugt selbstfurchende Schraube eingedreht wird.

Diese Schraubverbindung hat sich in der Praxis bewährt; dennoch ist sie nicht frei von Nachteilen. Zum einen birgt der Werkstoff der Schraube ein gewisses Fehlerpotential. Späne, Grate oder andere metallische Partikel, die an der schraube anhaften, können sich lösen und auf die Leiterbahnen der Platine gelangen. Das führt in aller Regel zu einer Fehlfunktion des elektrischen Geräts und ist daher unbedingt zu vermeiden.

Das automatisierte Herstellen dieser Schraubverbindung ist vergleichsweise aufwändig, da der Einschraubprozess im Wesentlichen über das Drehmoment gesteuert und überwacht wird. Der Kopf der Schraube reibt am Ende des Schraubvorgangs gegen die Oberfläche der Platine und würde eine dort verlaufende Leiterbahn beschädigen.

Aus der DE 10 2013 001 321 B4 ist ein Verfahren zum Fügen von Bauteilen bekannt, bei der in einem Grundteil eine zylindrische Bohrung vorhanden ist und ein zylindrischer Zapfen des zu fügenden Bauteils in diese zylindrische Bohrung eingeführt wird. Um die beiden Bauteile dauerhaft miteinander zu verbinden, wird ein Klebstoff zwischen Zapfen und der zylindrischen Bohrung eingebracht und die Bauteile miteinander verklebt. Nachteilig an diesem Fügeverfahren ist die relativ lange Abbindezeit des Klebstoffs. Erst wenn der Klebstoff abgebunden hat, ist die Verbindung fest. Daher hat auch dieses Verfahren Nachteile, die insbesondere bei der Herstellung großer Stückzahlen und sehr hohen Anforderungen an die Prozesssicherheit besonders zu Buche zu schlagen.

Aus der DE 10 2011 017 314 A1 sind eine Vorrichtung und ein Verfahren zum Fügen einer Leiterplatte und eines Leiterplattenträgers bekannt. Dabei werden Presskontaktstifte des Leiterplattenträgers in korrespondierende Kontaktlöcher der Leiterplatte gedrückt. Der Erfindung liegt die Aufgabe zugrunde, eine Baugruppe bereitzustellen, umfassend ein Grundteil und eine Platine, wobei die Platine mit dem Grundteil fest verbunden ist, welche die Nachteile des Standes der Technik vermeidet. Insbesondere soll das Verfahren prozesssicher und einfach automatisierbar sein. Darüber hinaus soll die Gefahr von Beschädigungen der auf der Platine aufgedruckten Leiterbahnen verringert werden.

Diese Aufgabe wird erfindungsgemäß bei einer Baugruppe umfassend ein Grundteil und eine Platine, wobei das Grundteil mindestens einen Tubus mit einer Bohrung umfasst, wobei die Platine mindestens eine Öffnung aufweist und wobei die Platine an dem Grundteil durch ein Befestigungselement mit einem Kopf und einem Schaft befestigt ist, und wobei der Schaft durch die Öffnung der Platine in die Bohrung des Tubus ragt, dadurch gelöst, dass der Schaft des Befestigungselements einen kegelstumpfförmigen Abschnitt aufweist, dass das Befestigungselement aus einem thermoplastischen Kunststoff besteht, und dass der Schaft des Befestigungselements durch Reibschweißen mit dem Tubus des Grundteils unlösbar verbunden ist.

Dadurch, dass das Befestigungselement aus einem thermoplastischen Kunststoff besteht, ist es möglich, das Befestigungselement durch Reibschweißen in der Bohrung des Tubus zu befestigen. Weil das Befestigungselement nicht aus Metall, sondern aus thermoplastischem Kunststoff besteht, können sich keine metallischen Partikel von dem Befestigungselement lösen und auf die Platine gelangen.

Das erfindungsgemäße Befestigungselement erlaubt es auch, den Fügeprozess einfacher zu automatisieren. Eine Steuerung und Überwachung des Drehmoments während des Fügevorgangs ist nicht erforderlich. Es ist vielmehr ausreichend, das Befestigungselement in Rotation zu versetzen und gleichzeitig eine Vorschubbewegung durchzuführen, bis die Unterseite des Kopfs auf der Oberseite der Platine aufliegt oder die Vorschubbewegung kurz vorher zu beenden, so dass die Unterseite des Kopfs die Oberseite der Platine nicht berührt.

Anders ausgedrückt: Es muss nur die Position des Kopfs des erfindungsgemäßen Befestigungselements erfasst werden. Das ist relativ einfach automatisierbar. Sobald der Kopf des Befestigungselements eine vorgegebene axiale Position erreicht hat, wird der Reibschweißvorgang beendet, d.h. das Befestigungselement wird nicht mehr angetrieben, sondern steht still. Es kann wahlweise eine axiale Anpresskraft ab diesem Zeitpunkt aufgebracht werden um eine Vorspannung in der Fügestelle zu erzeugen. Sobald der thermoplastische Kunststoff des Schafts und/oder des Tubus ihre Schmelztemperatur unterschritten haben, ist die Reibschweißverbindung fest und die Baugruppe kann einer weiteren Bearbeitung zugeführt oder für den Versand an den Einbauort vorbereitet werden.

Es ist sehr viel einfacher, die axiale Position des Kopfs des Befestigungselements zur Steuerung bzw. zum Beenden des Reibschweißvorgangs zu verwenden als eine auf der Drehmomentüberwachung basierte Steuerung des Einschraubvorgangs, wie es bei selbstfurchenden Schrauben der Fall sein muss.

Ein weiterer Vorteil der erfindungsgemäßen Baugruppe ist darin zu sehen, dass die Unterseite des Kopfs des Befestigungselements keinen direkten Reibkontakt mit der Oberseite der Platine haben muss. Dies bedeutet, dass die Oberseite der Platine durch den Reibschweißvorgang nicht beeinträchtigt wird. Daher können unter dem Kopf der Platine sogar aufgedruckte Leiterbahnen verlaufen. Im Folge dessen können die Abmessungen der Platine bei gleicher Funktionalität verringert werden.

Es ist aber in vielen Anwendungen vorteilhaft, wenn nach dem Ende des Reibschweißvorgangs (Stopp der Drehbewegung) eine axiale Kraft auf den Kopf des Befestigungselements ausgeübt wird, um die Bauteile (Kopf des Befestigungselements, Platine und Grundteil) ohne Spalt und Spiel zusammenzubringen. Das ist oftmals sogar erforderlich, weil ein Spalt zu einem "Klappern" der Baugruppe führen würde.

Ein Vorteil des erfindungsgemäßen Verfahrens ist, dass im Vergleich zum Schrauben keine Reibung zwischen Platine und dem Kopf des Befestigungselements stattfindet.

Zwischen der Unterseite des Kopfs des Befestigungselements und der Oberseite der Platine kann aber ein Spalt von beispielsweise 0,1 mm Dicke verbleiben, so dass auch Fertigungstoleranzen in der Dicke der Platine und beim Kopf des Befestigungselements ausgeglichen werden können. Es ist dann auch sichergestellt, dass kein ungewünschter Reibkontakt zwischen der Unterseite des Kopfs und der Platine entsteht. Selbstverständlich ist es aber auch möglich, den Reibschweißvorgang so lange fortzuführen, bis sich die Unterseite des Kopfs des Befestigungselements in Anlage an der Oberseite der Platine befindet.

Weil die Reibschweißverbindung eine stoffschlüssige Verbindung ist, kann die Länge des Tubus und auch des Befestigungselements - verglichen mit einer Schraubverbindung - reduziert werden. Dies bedeutet, dass die Platine näher an das Grundteil heranrücken kann, so dass sich das von der Baugruppe beanspruchte Volumen reduziert. Dies ist ein weiterer, durchaus erheblicher Vorteil der erfindungsgemäßen Baugruppe.

Durch die stoffschlüssige und nicht lösbare Verbindung zwischen dem Schaft des Befestigungselements und dem Tubus ist ein unbeabsichtigtes Lösen der Verbindung, beispielsweise durch Vibrationen oder Temperaturschwankungen, ausgeschlossen.

Die erfindungsgemäße Reibschweißverbindung benötigt weniger Baulänge als eine vergleichbare Schraubverbindung. Als Faustformel kann man angeben, dass eine Länge der erfindungsgemäßen Reibschweißverbindung von etwa 0,5 x dem Durchmesser des Schafts des Befestigungselements ausreicht.

Es ist weiter ausgeschlossen, dass die Platine wieder von dem Grundteil entfernt wird. Wenn nämlich der Kopf des Befestigungselements, nachdem das Befestigungselement mit dem Tubus durch Reibschweißen miteinander verbunden sind, durch ein Werkzeug, wie z.B. einen Schraubendreher, gedreht wird, schert der Kopf ab. Dadurch werden Manipulationsversuche oder unzulässige Reparaturversuche an der Baugruppe einfach erkannt. Dass ist ein Vorteil bezüglich der Gewährleistung des Herstellers der Baugruppe. Unqualifizierte bzw. ungewollte Reparaturversuche können somit auf einfache Weise visuell erkannt und nachgewiesen werden.

Schließlich kann das erfindungsgemäß Befestigungselement die selbstfurchenden Schrauben ersetzen, ohne Änderungen am Grundteil oder der Platine vornehmen zu müssen. Insbesondere kann die Bohrung der Tuben unverändert bleiben. Das erleichtert den Umstieg von bereits in Serie gefertigten geschraubten Baugruppen auf die erfindungsgemäße Baugruppe mit einer Reibschweißverbindung erheblich.

In weiterer vorteilhafter Ausgestaltung der Erfindung ist auch die mindestens eine Bohrung in dem Grundteil kegelstumpfförmig. Dadurch ergibt sich beim Einführen des Befestigungsteils eine große Kontaktfläche zwischen dem Schaft des Befestigungselements und der Bohrung, so dass der erfindungsgemäße Reibschweißvorgang gleichzeitig auf der gesamten Kontaktfläche beginnt.

Es hat sich als vorteilhaft erwiesen, wenn der Kegelwinkel des Schafts bzw. der Bohrung größer oder gleich 0,5° ist und kleiner oder gleich 3° ist.

In einer bevorzugten Weiterbildung der Erfindung besteht zumindest der Tubus des Grundteils ebenfalls aus einem thermoplastischen Kunststoff. Dann gehen beim Reibschweißen das Material sowohl des Schafts als auch des Tubus kurzzeitig in den geschmolzenen Zustand über und die Materialien beider Bauteile verbinden sich stoffschlüssig miteinander.

In jedem Fall ist der Tubus aus einem Material, das sich durch Reibschweißen mit dem Schaft des Befestigungselements verbindet. Es ist auch möglich, dass das aufgeschmolzene Material des Schafts mit der Bohrung im Tubus verklebt, ähnlich wie beim Heißkleben, ohne dass ein Aufschmelzen der Oberfläche des Tubus erfolgt.

Um die Belastbarkeit des Befestigungselements zu erhöhen, kann das Befestigungselement aus einem faserverstärkten thermoplastischen Kunststoff mit einer thermoplastischen Matrix und Fasern aus Kohlenstoff, Glas und/oder Aramid bestehen. Faseranteile von 10 bis 50 Gewichts-%, bevorzugt von etwa 30 Gewichts-%, haben sich als vorteilhaft erwiesen. Als thermoplastische Matrix für das Befestigungselement haben sich Polyamid, Polypropylen, Polyethylen und PC-ABS als geeignet erwiesen.

Um das Befestigungsmittel beim Reibschweißvorgang in Drehung versetzen zu können, weist in weiterer vorteilhafter Ausgestaltung der Kopf des Befestigungsmittels Formschlussmittel zum Herstellen einer lösbaren Drehverbindung mit einer Spindel oder Antriebsvorrichtung auf. Diese Antriebsvorrichtung kann Teil einer Reibschweißmaschine sein, welche den Kopf des Befestigungsmittels greift und in Drehung versetzt.

Die Formschlussmittel können als Vertiefung in dem Kopf ausgebildet sein. Beispielsweise kann die Vertiefung als Innensechsrund oder Innensechskantprofil ausgebildet sein. Dann weist die Antriebsvorrichtung einen Stift mit einem komplementär geformten Innensechskant auf. Wenn der Stift in die Vertiefung im Kopf des Befestigungsmittels einfährt, wird die Drehverbindung hergestellt.

Durch eine Presspassung kann der Stift des Antriebsmittels in der Vertiefung kraftschlüssig gehalten werden, so dass eine gesonderte Spannung/Befestigung des Befestigungsmittels in der Antriebsvorrichtung nicht mehr erforderlich ist.

Nachdem der Reibschweißvorgang abgeschlossen ist, kann das Antriebsmittel bzw. der Kopf ohne Weiteres wieder in axialer Richtung herausgezogen werden.

Es ist jedoch auch möglich, dass die Formschlussmittel als Vorsprung an dem Kopf ausgebildet sind. Dann weist die Antriebsvorrichtung eine komplementäre Vertiefung auf, welche den Vorsprung am Kopf des Befestigungsmittels aufnimmt.

Selbstverständlich ist es auch möglich, die Außenkontur des Kopfs so zu gestalten, dass er Drehmomente übertragen kann. Zum Beispiel kann der Kopf als Sechskantkopf ausgeführt sein. Es ist aber auch möglich, die Außenkontur des Kopfs als Gleichdick oder Polygon auszubilden. Diese Polygon-Außenkontur kann bei kleinen Abmessungen große Drehmomente sicher übertragen.

In weiterer vorteilhafter Ausgestaltung weist der Schaft des Befestigungsmittels gegenüber der Bohrung im Grundteil ein Übermaß auf, so dass vor dem Fügen von Befestigungsmittel und Grundteil zwischen der Unterseite des Kopfs und der Oberseite der Platine ein Abstand vorhanden ist. Dieser Abstand kann beispielsweise 10 mm betragen, weil durch den kleinen Kegelwinkel des Schafts das relativ kleine radiale Übermaß in einen deutlich größeren axialen Abstand umgesetzt wird.

Dieses radiale Übermaß bestimmt die Schweißzugabe der Reibschweißverbindung. Der relative große axiale Abstand zwischen Kopf und Platine kann zur visuellen Kontrolle der Schweißzugabe genutzt werden.

Wenn man nämlich ein Befestigungsmittel in die Bohrung des Tubus steckt, dann lässt sich der Abstand zwischen der Unterseite des Kopfs und der Platine bzw. der Unterseite des Kopfs und dem oberen Ende des Tubus leicht feststellen und prüfen, ob dieser Abstand innerhalb der geforderten Toleranzen liegt.

Es versteht sich von selbst, dass eine Platine in der Regel mehrere Öffnungen hat. Beispielsweise können vier oder sechs Öffnungen vorhanden sein und dementsprechend sind an der gleichen Stelle Schraubtuben in dem Grundteil vorhanden, so dass die Platine mit Hilfe mehrerer erfindungsgemäßer Befestigungselemente mit dem Grundteil verbunden werden kann.

Die eingangs genannten Vorteile werden auch realisiert durch ein Verfahren zum Fügen einer Baugruppe nach einem der vorhergehenden Ansprüche, wobei in einem ersten Schritt die Platine auf dem Grundteil so angeordnet wird, dass die Öffnungen der Platine mit den Bohrungen der Tuben im Grundteil fluchten. Anschließend wird der Schaft eines Befestigungselements durch jede Öffnung der Platine gesteckt und in die Bohrung eines Tubus eingeführt. Im Anschluss daran oder gleichzeitig kann das Befestigungselement in Drehung versetzt werden und langsam in axialer Richtung bewegt werden (Vorschubbewegung), so dass es zu einem Kontakt zwischen dem Schaft und der Bohrung kommt. Aufgrund der Drehbewegung des Befestigungselements wird das Material im Bereich der Kontaktfläche über den Schmelzpunkt erwärmt. Dadurch entsteht eine Reibschweißverbindung. Der Prozess des Reibschweißens wird unterbrochen, bevor die Unterseite des Kopfs die Oberseite der Platine berührt. Dadurch ist sichergestellt, dass die Platine nicht durch die Rotation des Befestigungsmittels beschädigt wird.

Besonders bevorzugt ist es, wenn während des Reibschweißvorgangs eine Vorschubbewegung des Befestigungselements in axialer Richtung erfolgt.

Weitere Vorteile und vorteilhafte Ausgestaltungen der Erfindung sind der nachfolgenden Zeichnung, deren Beschreibung und den Patentansprüchen entnehmbar. Alle in der Zeichnung, deren Beschreibung und den Patentansprüchen offenbarten Merkmale können sowohl einzeln als auch in beliebiger Kombination miteinander erfindungswesentlich sein.

### Zeichnung

Es zeigen:
- Figur 1: einen Teilschnitt durch eine erfindungsgemäße Baugruppe;
- Figur 2: eine detaillierte und vergrößerte Darstellung des Befestigungselements;
- Figur 3: eine Ansicht von oben auf den Kopf des Befestigungselements;
- Figur 4: einen vergrößerten Ausschnitt des Kopfs des Befestigungselements; und
- Figur 5: einen Schnitt durch eine Baugruppe vor dem Fügen.

### Beschreibung des Ausführungsbeispiels

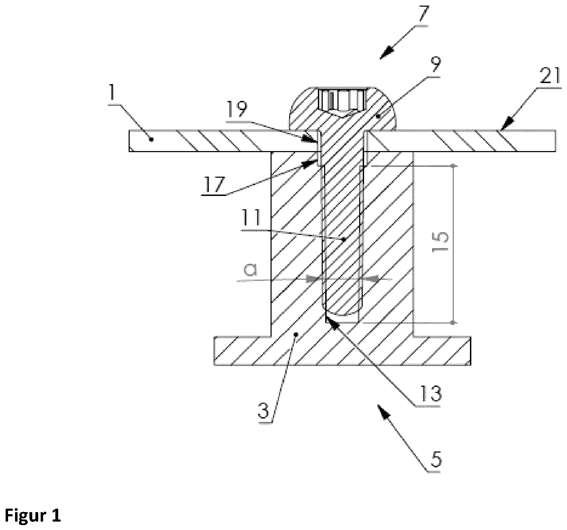

In der Figur 1 ist eine erfindungsgemäße Baugruppe in einem Teilschnitt dargestellt. Die erfindungsgemäße Baugruppe umfasst eine Platine 1 und ein Grundteil 5. Das Grundteil 5 weist mindestens einen Tubus 3, in der Regel jedoch mehrere Tuben auf, von denen in der Figur 1 nur einer zu sehen ist.

Das Grundteil 5 kann beispielsweise eine Trägerplatte sein, die dazu dient, die Platine 1 zu halten und zu stützen, so dass mechanische Belastungen von der Platine 1 ferngehalten werden. Das Grundteil 5 kann aber auch der untere Teil eines geschlossenen Gehäuses sein, auf den ein Deckel (nicht dargestellt) gesetzt wird, um die Platine 1 auch vor Staub und Feuchtigkeit zu schützen.

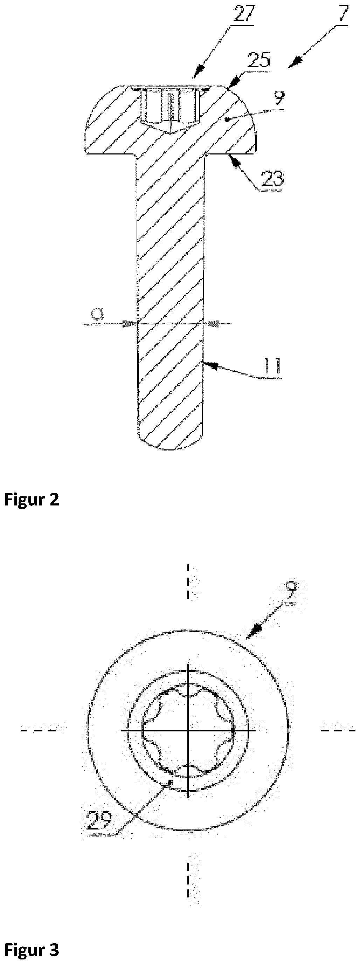

Die Hauptkomponenten der Baugruppe, nämlich das Grundteil 5 und die Platine 1, werden durch ein erfindungsgemäßes Befestigungselement 7 miteinander verbunden. Das Befestigungselement 7 umfasst einen Kopf 9 und einen Schaft 11 und sieht auf den ersten Blick ähnlich wie eine Schraube ohne Gewinde oder ein Niet aus. Das Befestigungselement 7 ist in der Figur 2 einzeln dargestellt und wird weiter unten im Zusammenhang mit der Figur 2 näher erläutert. Mindestens der Schaft 11 des Befestigungselements 7 besteht aus einem thermoplastischen Kunststoff und wird durch Reibschweißen mit dem Tubus 3 des Grundteils 5 verbunden.

Zu diesem Zweck ist in dem Tubus 3 eine Bohrung 13 ausgebildet. Zumindest der in Figur 1 untere Teil 15 der Bohrung 13 ist in der Regel kegelstumpfförmig mit einem Kegelwinkel von zum Beispiel 1°. Dieser Bereich wird auch als kegelstumpfförmiger Abschnitt 15 bezeichnet. Der Durchmesser der Bohrung 13 ist an dem in Figur 1 oberen Ende des Tubus 3 am größten. Kegelwinkel in einem Bereich zwischen 0,5° und 3° haben sich als geeignet erwiesen. In vielen Fällen ist ein Kegelwinkel α von 1° sehr gut geeignet.

An dem in Figur 1 oberen Ende der Bohrung 13 ist eine optionale Durchmessererweiterung 17 vorgesehen. Im Bereich der Durchmessererweiterung 17 ist kein Kontakt zwischen dem Schaft 11 des Befestigungselements 7 und der Bohrung 13 vorhanden. Dort findet auch kein Reibschweißvorgang statt. Das hat den Vorteil, dass das plastifizierte Material beim Reibschweißen nicht in Berührung mit der Platine 1 kommt.

Eventuell vorhandenes überschüssiges Material, das beim Reibschweißen entsteht, wird in dem ringförmigen Zwischenraum zwischen der Durchmessererweiterung 17 und dem Schaft 11 des Befestigungselements 7 aufgenommen.

An dem in Figur 1 oberen Ende des Tubus 3 ist die Platine 1 aufgelegt. Sie weist eine Öffnung 19 auf, die in ihren Abmessungen und ihrer Lage so auf die Bohrung 13 abgestimmt ist, dass das Befestigungselement 7 mit seinem Schaft 11 durch die Öffnung 19 in die Bohrung 13 des Tubus 3 eingeführt werden kann.

In der Figur 1 liegt eine Unterseite 23 (siehe Figur 2) des Kopfs 9 auf der Platine 1 auf. Es ist jedoch auch möglich, dass ein kleiner Spalt von beispielsweise einem Zehntel Millimeter zwischen dem Kopf 9 und der Platine 1 nach dem Ende des Reibschweißvorgangs bestehen bleibt. Dieser Spalt ist in der Figur 1 nicht sichtbar. Durch den Spalt ist gewährleistet, dass der Kopf 9 die Oberseite 21 der Platine 1 Während und nach dem Reibschweißen nicht berührt. Wie bereits erwähnt kann - nachdem der Reibschweißvorgang abgeschlossen ist - eine Kraft in axialer Richtung auf den Kopf des stillstehenden Befestigungselements ausgeübt werden, bis der Spalt zwischen der Unterseite 23 des Kopfs 9 und der Platine 1 verschwunden ist.

Dadurch können Leiterbahnen (nicht dargestellt) auf der Oberseite 21 der Platine direkt unter dem Kopf 9 des Befestigungselements verlaufen. In anderen Worten: Die Grundfläche der Platine wird besser ausgenutzt oder man kann bei gleicher Zahl von Leiterbahnen die Platine kleiner bauen.

Gefügt wird die Baugruppe, indem die Platine 1 auf das Grundteil 5 so aufgesetzt wird, dass die Öffnung 19 mit der Bohrung 13 fluchtet. Anschließend wird ein erfindungsgemäßes Befestigungselement 7 aus einem plastifizierbaren Kunststoff mit seinem Schaft 11 durch die Öffnung 19 in die Bohrung 13 eingeführt. Dann wird das Befestigungselement 7 in Rotation versetzt und weiter in die Bohrung 13 bewegt (Vorschub), so dass ein Reibschweißvorgang zwischen dem Schaft 11 des Befestigungselements und dem kegelstumpfförmigen Abschnitt 15 der Bohrung 13 stattfindet.

Sobald die Oberflächen von Schaft 11 und Bohrung 13 ausreichend plastifiziert sind, wird die Drehbewegung des Befestigungselements 7 beendet. Die Fügestelle kühlt ab und es entsteht eine stoffschlüssige Verbindung zwischen dem Schaft 11 und dem Tubus 3 des Grundteils 5.

In der Figur 2 ist das Befestigungselement 7 in einem Längsschnitt in einem Längsschnitt dargestellt.

In der Figur 3 ist der Kopf 9 des Befestigungselements noch etwas vergrößert dargestellt. Der Kopf 9 weist eine Unterseite 23 auf. In der Mitte der Oberseite 25 des Kopfs 9 ist eine Vertiefung 27 ausgebildet. Diese Vertiefung 27 ist bei dem dargestellten Ausführungsbeispiel als sogenanntes Innensechsrund-Profil ausgebildet.

In der Figur 3 ist der Kopf 9 in einer Ansicht von oben dargestellt. Aus dieser Ansicht von oben ist die Vertiefung 27 und das erwähnte innensechsrund-Profil gut zu erkennen. Die Vertiefung 27 ist eine bevorzugte Ausführungsform eines Formschlussmittels zum Herstellen einer lösbaren Drehverbindung zwischen einem Antriebswerkzeug (nicht dargestellt) und dem Befestigungselement 7. Diese Drehverbindung ist erforderlich, um die zum Reibschweißen erforderlichen Drehmomente von dem Antriebsmittel auf das Befestigungselement 7 zu übertragen.

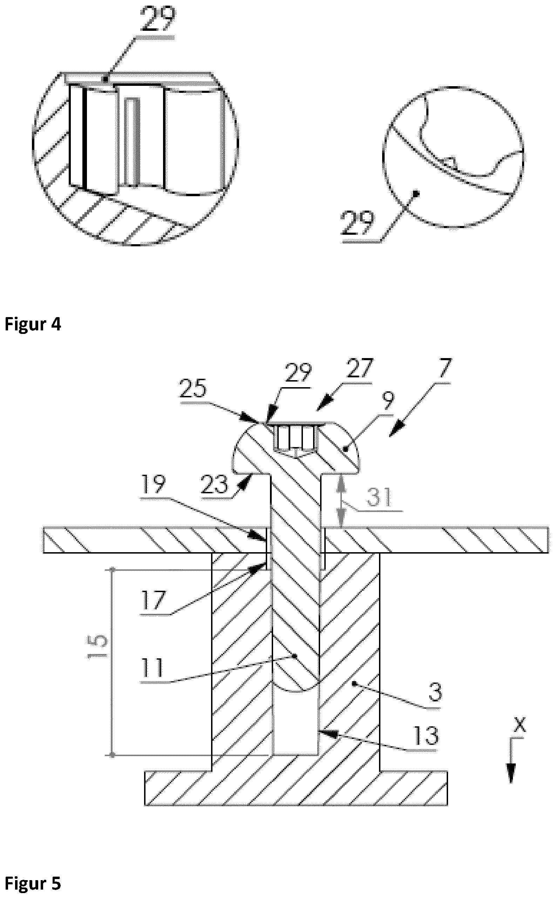

In der Figur 4 ist ein Teil der Vertiefung 27 vergrößert dargestellt. Aus dieser Darstellung ergibt sich, dass die Vertiefung 27 an ihrem oberen Ende in einer Positionierfläche 29 endet. Diese Positionierfläche 29 dient dazu, eine Antriebsvorrichtung (nicht dargestellt) in axialer Richtung exakt zu positionieren, so dass über die Position des Antriebswerkzeugs in axialer Richtung die Position der Unterseite 23 des Kopfs 9 exakt definiert ist.

Das ist besonders vorteilhaft, wenn das Befestigungselement 7 erfindungsgemäß durch Reibschweißen in dem Tubus 3 befestigt wird. Dann nämlich kann der Abstand zwischen Kopf 9 und Platine 1 einfach und genau bestimmt werden. Wie weiter oben bereits erläutert, ist die Kenntnis der Position der Kopfs 9 wichtig, um die Vorschubbewegung der Antriebsvorrichtung zu beenden, kurz bevor die Unterseite 23 des Kopfs 9 die Oberseite 21 der Platine 1 berührt. Dadurch wird ein Reiben des Kopfs 9 an der Oberseite 21 der Platine vermieden. Diese Positionierfläche 29 verläuft parallel und in einem definierten Abstand zu der Unterseite 23 des Kopfs 9.

Alternativ kann die Vorschubbewegung der Antriebsvorrichtung auch beendet werden, wenn die Unterseite 23 des Kopfs 9 die Oberseite 21 der Platine 1 berührt. Während die durch das Reibschweißen erzeugte Schmelze abkühlt und erstarrt, wird der Kopf 9 in dieser Position gehalten. Bei Bedarf kann durch das Antriebselement einer Reibschweißvorrichtung eine definierte Anpresskraft in den Kopf des Befestigungselements eingeleitet werden. Dabei dreht sich das Antriebselement nicht. Dadurch wird eine definierte Anpresskraft zwischen dem Kopf 9 und der Platine erreicht bzw. eingestellt.

In der Figur 5 ist die Baugruppe vor dem Reibschweißen dargestellt. Diese Darstellung weist viele Übereinstimmungen mit der Figur 1 auf. Ein wesentlicher Unterschied besteht darin, dass das Befestigungselement 7 mit seinem Schaft 11 nur lose in die Bohrung 13 des Tubus 3 eingesteckt ist.

Anhand der Figur 5 kann das radiale Übermaß des Schafts 11 des Befestigungselements 7 bezogen auf den kegelstumpfförmigen Abschnitt 15 der Bohrung 13 veranschaulicht werden:
Wegen des Übermaßes und weil der Schaft 11 kegelstumpfförmig ist, bleibt der Schaft 11 in dem Abschnitt 15 der Bohrung 13 "stecken", bevor der Kopf 9 auf der Platine 1 aufliegt. Das radiale Übermaß zeigt sich stark vergrößert in dem Abstand 31 zwischen der Unterseite 23 des Kopfs 9 und der Oberseite 21 der Platine 1.

Der Abstand 31 zwischen der Unterseite 23 des Kopfs 9 und der Oberseite 21 der Platine ist ein Maß für das Übermaß in radialer Richtung zwischen dem Schaft 11 und der Bohrung 13. Das radiale Übermaß und der Abstand 31 sind über den Tangens des Kegelwinkels α miteinander verbunden. Weil der Abstand 31 sehr viel größer ist als das radiale Übermaß kann er sehr einfach zur visuellen Kontrolle des radialen Übermaßes genutzt werden.

Ausgehend von der in Figur 5 dargestellten Position des Befestigungselements 7 relativ zu der Öffnung 19 in der Platine 1 und der Bohrung 13 des Tubus 3 beginnt der Reibschweißvorgang.

Dazu wird das Befestigungselement 7 mit Hilfe einer Antriebsvorrichtung (nicht dargestellt) in Drehung versetzt und gleichzeitig in Richtung der X-Achse bewegt (Vorschubbewegung). Durch die Gleitreibung zwischen dem Schaft 11 und dem kegelstumpfförmigen Abschnitt 15 der Bohrung 13 entsteht Reibungswärme, der Schaft 11 und die Bohrung 13 werden durch die Reibungswärme an ihrer Oberfläche zunehmend weicher, so dass das Befestigungselement 7 sukzessive weiter in die Bohrung 13 bewegt werden kann. Die dazu erforderliche Vorschubkraft ist klein.

Sobald die Unterseite 23 des Kopfs 7 die gewünschte Position kurz oberhalb oder auf der Oberfläche 21 der Platine 1 erreicht, ist der Reibschweißvorgang abgeschlossen.

Die Drehung des Befestigungselements 7 wird beendet; die Schmelzzone zwischen dem Schaft 11 und der Bohrung 13 kühlt ab und wird wieder fest. Danach ist die Reibschweißverbindung zwischen dem Befestigungselement 7 und dem Tubus 3 fertiggestellt.

Die Platine 1 ist sicher ohne mechanische Beanspruchung, vor allem an der Oberseite 21 der Platine, an dem Grundteil befestigt.

## Patentansprüche

1. Baugruppe umfassend ein Grundteil (5) und eine Platine (1), wobei das Grundteil (5) mindestens einen Tubus (3) mit einer Bohrung (13) umfasst, wobei die Platine (1) mindestens eine Öffnung (19) aufweist, und wobei die Platine (1) an dem Grundteil (5) durch ein Befestigungselement mit einem Kopf und einem Schaft befestigt ist, wobei der Schaft durch die Öffnung (19) der Platine (1) in die Bohrung (13) des Tubus (3) ragt und der Schaft (11) des Befestigungselements (7) einen kegelstumpfförmigen Abschnitt (15) aufweist, **dadurch gekennzeichnet, dass** das Befestigungselement (7) aus einem thermoplastischen Kunststoff besteht und durch Reibschweißen unlösbar mit dem Grundteil (5) verbunden ist.

2. Baugruppe nach Anspruch 1, **dadurch gekennzeichnet, dass** die mindestens eine Bohrung (13) in dem Tubus (3) des Grundteils (5) kegelstumpfförmig ist.

3. Baugruppe nach Anspruch 1 oder 2, **dadurch gekennzeichnet, dass** ein Kegelwinkel (α) des Schafts (11) und ein Kegelwinkel (α) der Bohrung (13) in dem Tubus (3) gleich sind.

4. Baugruppe nach einem der vorhergehenden Ansprüche, **dadurch gekennzeichnet, dass** der Kegelwinkel (α) des Schafts (11) größer oder gleich 0,5 ° ist und kleiner oder gleich 3° ist.

5. Baugruppe nach einem der vorhergehenden Ansprüche, **dadurch gekennzeichnet, dass** das Befestigungselement (7) aus einem faserverstärkten Kunststoff mit einer thermoplastischen Matrix und Fasern aus Kohlenstoff, Glas und/oder Aramid besteht.

6. Baugruppe nach einem der vorhergehenden Ansprüche, **dadurch gekennzeichnet, dass** das Befestigungselement (7) einen Faseranteil von 10 bis 50 Gewicht-%, besonders bevorzugt von 30 Gewicht-%, aufweist.

7. Baugruppe nach einem der vorhergehenden Ansprüche, **dadurch gekennzeichnet, dass** der Kopf (9) des Befestigungsmittels (7) zur Aufnahme in einer Antriebsvorrichtung und/oder zur Übertragung von Drehmomenten ausgebildet ist.

8. Baugruppe nach Anspruch 6, **dadurch gekennzeichnet, dass** der Kopf (9) des Befestigungsmittels (7) Formschlussmittel zum Herstellen einer lösbaren Drehverbindung mit einer Spindel oder Antriebsvorrichtung aufweist.

9. Baugruppe nach Anspruch 8, **dadurch gekennzeichnet, dass** die Formschlussmittel als Vertiefung (27) in dem Kopf (9) ausgebildet sind.

10. Baugruppe nach Anspruch 7, **dadurch gekennzeichnet, dass** die Formschlussmittel als Vorsprung an dem Kopf (9) ausgebildet sind.

11. Baugruppe nach einem der Ansprüche 7 bis 10, **dadurch gekennzeichnet, dass** eine Außenkontur des Kopfs (9) zur Übertragung von Drehmomenten ausgebildet ist.

12. Baugruppe nach einem der Ansprüche 7 bis 11, **dadurch gekennzeichnet, dass** an einer Oberseite (25) des Kopfs (9) eine Positionier-Fläche (29) ausgebildet ist, und dass die Positionier-Fläche (29) und eine Unterseite (23) des Kopfs (9) parallel zueinander verlaufen.

13. Baugruppe nach einem der vorhergehenden Ansprüche, **dadurch gekennzeichnet, dass** der Schaft (11) des Befestigungsmittels (7) gegenüber der Bohrung (13) im Tubus (3) ein Übermaß aufweist, so dass vor dem Fügen der Baugruppe zwischen der Unterseite (23) des Kopfs (9) und der Oberseite (21) der Platine (1) ein Abstand (31) vorhanden ist.

14. Baugruppe nach einem der vorhergehenden Ansprüche, **dadurch gekennzeichnet, dass** in dem Grundteil (5) mehrere Tuben (3) und in der Platine (1) mehrere Öffnungen (19) vorhanden sind.

15. Verfahren zum Fügen einer Baugruppe nach einem der vorhergehenden Ansprüche, **gekennzeichnet durch** folgende Verfahrensschritte:
Anordnen der Platine (1) auf dem Grundteil (5), so dass die mindestens eine Öffnung (19) der Platine (1) mit der Bohrung (13) des mindestens einen Tubus (3) fluchtet,
Einführen des Schafts (11) eines Befestigungselements (7) aus einem thermoplastischen Kunststoff durch eine Öffnung (19) der Platine (1) in eine Bohrung (13) des Tubus (3) und
Unlösbares Verbinden von Befestigungselement (7) und Grundteil (5) durch Reibschweißen.

16. Verfahren nach Anspruch 15, **dadurch gekennzeichnet, dass** das Reibschweißen beendet wird, bevor die Unterseite (23) des Kopfs (9) die Oberseite (21) der Platine (1) berührt.

17. Verfahren nach Anspruch 15 oder 16, **dadurch gekennzeichnet, dass** während des Reibschweißens eine (Vorschub-)Bewegung des Befestigungselements (7) in axialer Richtung (X-Achse) erfolgt.

## Claims

1. Assembly comprising a base part (5) and a circuit board (1), the base part (5) comprising at least one tube (3) having a bore (13), the circuit board (1) having at least one opening (19), and the circuit board (1) being fastened to the base part (5) by a fastening element having a head and a shaft, the shaft projecting through the opening (19) in the circuit board (1) into the bore (13) of the tube (3) and the shaft (11) of the fastening element (7) having a frustoconical portion (15),
**characterized in that** the fastening element (7) consists of a thermoplastic material and is non-detachably connected to the base part (5) by friction welding.

2. Assembly according to claim 1, **characterized in that** the at least one bore (13) in the tube (3) of the base part (5) is frustoconical.

3. Assembly according to claim 1 or 2, **characterized in that** a cone angle (α) of the shaft (11) and a cone angle (α) of the bore (13) in the tube (3) are equal.

4. Assembly according to any of the preceding claims, **characterized in that** the cone angle (α) of the shaft (11) is greater than or equal to 0.5° and smaller than or equal to 3°.

5. Assembly according to any of the preceding claims, **characterized in that** the fastening element (7) consists of a fiber-reinforced plastics material having a thermoplastic matrix and fibers made of carbon, glass, and/or aramid.

6. Assembly according to any of the preceding claims, **characterized in that** the fastening element (7) has a fiber content of 10 to 50 wt.%, particularly preferably 30 wt.%.

7. Assembly according to any of the preceding claims, **characterized in that** the head (9) of the fastening means (7) is designed to be received in a drive device and/or to transmit torques.

8. Assembly according to claim 6, **characterized in that** the head (9) of the fastening means (7) has form-fitting means for producing a detachable rotary connection with a spindle or drive device.

9. Assembly according to claim 8, **characterized in that** the form-fitting means are in the form of a recess (27) in the head (9).

10. Assembly according to claim 7, **characterized in that** the form-fitting means are in the form of a projection on the head (9).

11. Assembly according to any of claims 7 to 10, **characterized in that** an outer contour of the head (9) is designed to transmit torques.

12. Assembly according to any of claims 7 to 11, **characterized in that** a positioning surface (29) is formed on an upper face (25) of the head (9), **and in that** the positioning surface (29) and a lower face (23) of the head (9) extend in parallel with one another.

13. Assembly according to any of the preceding claims, **characterized in that** the shaft (11) of the fastening means (7) is oversized in relation to the bore (13) in the tube (3), so that, before the assembly is joined, there is a gap (31) between the lower face (23) of the head (9) and the upper face (21) of the circuit board (1).

14. Assembly according to any of the preceding claims, **characterized in that** there is a plurality of tubes (3) in the base part (5) and a plurality of openings (19) in the circuit board (1).

15. Method for joining an assembly according to any of the preceding claims, **characterized by** the following method steps:
arranging the circuit board (1) on the base part (5) so that the at least one opening (19) in the circuit board (1) is aligned with the bore (13) of the at least one tube (3),
inserting the shaft (11) of a fastening element (7) made of a thermoplastic material through an opening (19) in the circuit board (1) into a bore (13) of the tube (3) and
non-detachably connecting the fastening element (7) and base part (5) by friction welding.

16. Method according to claim 15, **characterized in that** the friction welding is terminated before the lower face (23) of the head (9) touches the upper face (21) of the circuit board (1).

17. Method according to claim 15 or 16, **characterized in that** during friction welding, a (feed) movement of the fastening element (7) occurs in the axial direction (X-axis).

## Revendications

1. Ensemble comprenant une partie de base (5) et une platine (1), dans lequel la partie de base (5) comprend au moins un tube (3) avec un trou (13), dans lequel la platine (1) présente au moins une ouverture (19), et dans lequel la platine (1) est fixée à la partie de base (5) par un élément de fixation avec une tête et une tige, dans lequel la tige fait saillie à travers l'ouverture (19) de la platine (1) dans le trou (13) du tube (3) et la tige (11) de l'élément de fixation (7) présente une section tronconique (15), **caractérisé en ce que** l'élément de fixation (7) est constitué d'une matière thermoplastique et est relié de manière inamovible à la partie de base (5) par soudage par friction.

2. Ensemble selon la revendication 1, **caractérisé en ce que** le au moins un trou (13) dans le tube (3) de la partie de base (5) est tronconique.

3. Ensemble selon la revendication 1 ou 2, **caractérisé en ce qu'**un angle de cône (α) de la tige (11) et un angle de cône (α) du trou (13) dans le tube (3) sont égaux.

4. Ensemble selon l'une quelconque des revendications précédentes, **caractérisé en ce que** l'angle de cône (α) de la tige (11) est supérieur ou égal à 0,5 ° et inférieur ou égal à 3°.

5. Ensemble selon l'une quelconque des revendications précédentes, **caractérisé en ce que** l'élément de fixation (7) est constitué d'une matière plastique renforcée par des fibres avec une matrice thermoplastique et des fibres de carbone, de verre et/ou d'aramide.

6. Ensemble selon l'une quelconque des revendications précédentes, **caractérisé en ce que** l'élément de fixation (7) présente une proportion de fibres de 10 à 50 % en poids, de manière particulièrement préférée de 30 % en poids.

7. Ensemble selon l'une quelconque des revendications précédentes, **caractérisé en ce que** la tête (9) du moyen de fixation (7) est réalisée pour être reçue dans un dispositif d'entraînement et/ou pour transmettre des couples.

8. Ensemble selon la revendication 6, **caractérisé en ce que** la tête (9) du moyen de fixation (7) présente des moyens de liaison par complémentarité de forme pour établir une liaison rotative libérable avec une broche ou un dispositif d'entraînement.

9. Ensemble selon la revendication 8, **caractérisé en ce que** les moyens de liaison par complémentarité de forme sont réalisés comme un évidement (27) dans la tête (9).

10. Ensemble selon la revendication 7, **caractérisé en ce que** les moyens de liaison par complémentarité de forme sont réalisés comme une saillie sur la tête (9).

11. Ensemble selon l'une quelconque des revendications 7 à 10, **caractérisé en ce qu'**un contour extérieur de la tête (9) est réalisé pour transmettre des couples.

12. Ensemble selon l'une quelconque des revendications 7 à 11, **caractérisé en ce qu'**une surface de positionnement (29) est réalisée sur une face supérieure (25) de la tête (9), et **en ce que** la surface de positionnement (29) et une face inférieure (23) de la tête (9) s'étendent parallèlement l'une à l'autre.

13. Ensemble selon l'une quelconque des revendications précédentes, **caractérisé en ce que** la tige (11) du moyen de fixation (7) présente une surépaisseur par rapport au trou (13) dans le tube (3), de sorte qu'un espacement (31) est présent entre la face inférieure (23) de la tête (9) et la face supérieure (21) de la platine (1) avant l'assemblage de l'ensemble.

14. Ensemble selon l'une quelconque des revendications précédentes, **caractérisé en ce que** plusieurs tubes (3) sont présents dans la partie de base (5) et plusieurs ouvertures (19) sont présentes dans la platine (1).

15. Procédé pour assembler un ensemble selon l'une quelconque des revendications précédentes, **caractérisé par** les étapes de procédé suivantes :
la disposition de la platine (1) sur la partie de base (5), de sorte que la au moins une ouverture (19) de la platine (1) soit alignée avec le trou (13) du au moins un tube (3), l'introduction de la tige (11) d'un élément de fixation (7) composé d'une matière thermoplastique à travers une ouverture (19) de la platine (1) dans un trou (13) du tube (3) et
la liaison non libérable de l'élément de fixation (7) et de la partie de base (5) par soudage par friction.

16. Procédé selon la revendication 15, **caractérisé en ce que** le soudage par friction est terminé avant que la face inférieure (23) de la tête (9) ne touche la face supérieure (21) de la platine (1).

17. Procédé selon la revendication 15 ou 16, **caractérisé en ce que** pendant le soudage par friction, un mouvement (d'avance) de l'élément de fixation (7) est effectué dans la direction axiale (axe X).
